# EUROPEAN PATENT SPECIFICATION

(11) **EP 0 799 906 B1**
(45) Date of publication and mention of the grant of the patent: **03.07.2002**
(21) Application number: 97302304.7
(22) Date of filing: 03.04.1997
(51) Int. Cl.: C23C 16/12, C23C 16/20, H01L 21/00

(54) **Semiconductor device**
Halbleiterbauelement
Dispositif semi-conducteur

(30) Priority: 04.04.1996 US 14875
(43) Date of publication of application: 08.10.1997
(73) Proprietor: TEXAS INSTRUMENTS INCORPORATED, Dallas Texas 75265 (US)
(72) Inventor: Paranjpe, Ajit P., Sunnyvale, CA 94086 (US)
(74) Representative: Darby, David Thomas

(56) References cited:
- EP-A- 0 372 861
- EP-A- 0 561 588
- EP-A- 0 766 302
- US-A- 4 726 983
- US-A- 4 751 101

## Description

### FIELD OF THE INVENTION

The instant invention pertains to semiconductor device fabrication and processing and more specifically to controlling grain growth in chemical vapor deposition processing.

### BACKGROUND OF THE INVENTION

In many chemical vapor deposition (CVD) processes, grain size increases with increasing film thickness. This increase in grain size may be problematic since it enhances surface roughness. Enhanced surface roughness is a problem if the film is to be patterned (because errors are introduced in optical patterning) or if the film is being used for contact/via/trench fill (because voids will most likely be formed in small regions to be filled because of the large grain size). In addition, rough films exhibit higher resistivity due to surface roughness induced scattering, and the properties of films deposited on rough films may also be degraded.

While many deposition techniques other than CVD (such as plasma assisted deposition and physical vapor deposition) produce films with smaller grain sizes, they do not provide the conformality and stoichiometric control that CVD processes provide. In addition, even though there are some disadvantages to large grain sizes, there are also some benefits. Films with larger grain sizes have lower bulk resistivity and superior electromigration resistance.

EP-A-372 861 describes the inhibition of grain growth in metal film formation by CVD by the deposition of an auxiliary layer which causes renucleation of the metal on further deposition. U.S. Patent No. 4 726 983 suppresses electromigration in a sputtered aluminum layer by oxidizing the surface of the growing layer, a procedure that at the same time inhibits grain growth. The procedure is stated to be applicable also to an aluminum layer formed by CVD, but no details are given.

There remains a need, however, for a process in which a film's grain size can be controlled, thereby controlling the electromigration resistance of the film, the ability to fill a small structure with the deposited film, and the overall morphology and resistivity of the film.

### SUMMARY OF THE INVENTION

The present invention provides a method of forming an aluminum- or polysilicon-containing coating of a controlled grain size on a substrate which comprises forming on the substrate by chemical vapor deposition (CVD) a first aluminum or polysilicon layer, forming a thin intermediate layer, differing in grain structure from that of the first layer, on the first layer, and forming by CVD on the intermediate layer a second layer of the same material as the first layer, characterized in that the intermediate layer is formed by amorphizing the surface of the first layer or by depositing the same material that forms the first layer by plasma-assisted deposition or by physical vapor deposition.

Preferably, the intermediate layer is an interstitial layer. Preferably, the steps of forming the first layer, the thin intermediate layer on the first layer, and the second layer on the thin intermediate layer are repeated at least once.

Preferably, the first and second layers are formed to a thickness of 100 to 200 (1000 to 2000 Å ) nm, the intermediate layer being 5 to 50 nm (50 to 500 Å) thick.

### DETAILED DESCRIPTION OF THE DRAWINGS

As was stated above, in many CVD processes grain size of films increases with increasing film thickness. In one embodiment of this invention the grain size of the deposited CVD Al or CVD polysilicon film is controlled by interrupting the CVD process when the grain size becomes unacceptably large, forming (preferably depositing) an intermediate layer (preferably an amorphous/microcrystalline layer) which has a different grain pattern than the CVD film, and then continuing with the CVD process. This may be done a plurality of times to ensure that the grains do not grow too large, and thereby achieve the desired grain size distribution.

The intervening film may be formed by amorphizing the surface of the CVD film with a low energy moderate dose implant, or it can be amorphized by physical treatment. Alternatively, the intermediate layer may simply be deposited by plasma assisted deposition or physical vapor deposition (PVD). For example, to control the grain structure of a CVD Al film, the thermal CVD process can be interrupted approximately every 100 nm and a thin (preferably between 5 and 50 nm) Al film, formed by PVD or plasma assisted deposition, may be deposited. The advantage of a plasma-assisted CVD Al film instead of a PVD Al film is that the plasma assisted process can be performed in the same chamber as the CVD Al process, and is, therefore, less likely to affect throughput.

### BRIEF DESCRIPTION OF THE DRAWINGS

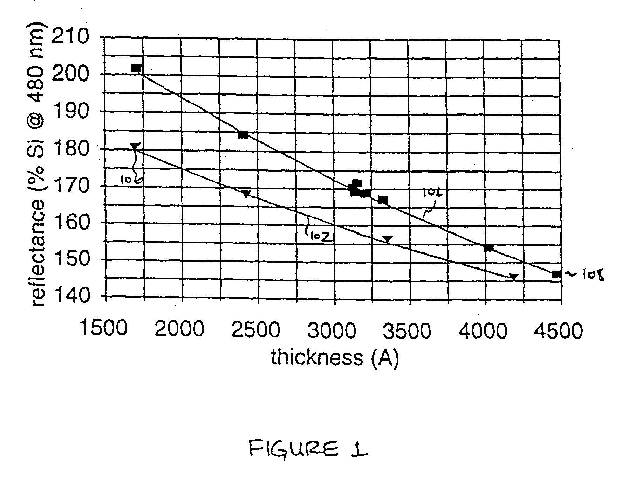

FIGURE 1 is a graph illustrating the reflectance of a CVD Al film (the x-axis represents the thickness of the top layer in a stack and the y-axis represents the reflectance of the CVD Al film).

In FIGURE 1, plot 104 illustrates the reflectance of a CVD Al film (whose thickness is given on the x-axis in Å, 10Å being 1 nm) which is formed on top of a 500Å thick TiN film. Plot 102 illustrates the reflectance of a CVD Al film (whose thickness is given on the x-axis in Å) which is formed on a 3000Å CVD Al layer with a microcrystalline material formed between the two CVD Al layers. As can be seen from point 106, the reflectance of a stack which is comprised of a 3000Å thick CVD Al layer, a microcrystalline thin layer, and a 1500Å CVD Al is approximately 185%. Referring to point 108, the reflectance of a 4500Å CVD Al film formed on a 500Å TiN film is approximately 145%. In reference to these two reflectance values, it is apparent that the stack which includes an intermediate layer has a smaller grain size when it is a total of 4500Å thick than a CVD Al layer which is 4500Å thick and which does not utilize the intermediate layer. The forming of a CVD Al layer on top of a TiN film, as shown in plot 104 of Figure 1, is not part of the present invention.

## Claims

1. A method of forming an aluminum- or polysilicon-containing coating of a controlled grain size on a substrate which comprises forming on the substrate by chemical vapor deposition (CVD) a first aluminum or polysilicon layer, forming a thin intermediate layer, differing in grain structure from that of the first layer, on the first layer, and forming by CVD on the intermediate layer a second layer of the same material as the first layer, **characterized in that** the intermediate layer is formed by amorphizing the surface of the first layer or by depositing the same material that forms the first layer by plasma-assisted deposition or by physical vapor deposition.

2. A method as claimed in claim 1, wherein the intermediate layer is formed by amorphization, and wherein amorphization is carried out by low energy moderate dose implant or by physical treatment.

3. The method of claim 1 or claim 2, further comprising repeating the steps of forming said first layer, said intermediate layer on said first layer, and said second layer on said intermediate layer at least once.

4. The method of any preceding claim, wherein said step of forming said first and second layers comprises forming said first and second layers to a thickness of 100 to 200 (1000 to 2000 Å) nm and said intermediate layer to a thickness of 5 to 50 (50 to 500 Å ) nm.

## Patentansprüche

1. Verfahren zum Bilden einer aluminium- oder polysiliciumhaltigen Beschichtung mit gesteuerter Korngröße auf einem Substrat, bei dem auf dem Substrat durch chemische Dampfabscheidung (CVD) eine erste Aluminium- oder Polysiliciumschicht gebildet wird, auf der ersten Schicht eine in der Kornstruktur von der der ersten Schicht verschiedene dünne Zwischenschicht gebildet wird und durch CVD auf der Zwischenschicht eine zweite Schicht aus dem gleichen Material wie die erste Schicht gebildet wird, **dadurch gekennzeichnet, daß** die Zwischenschicht durch Amorphisierung der Oberfläche der ersten Schicht oder durch Abscheidung des gleichen Materials, das die erste Schicht bildet, mittels plasmaunterstützter Abscheidung oder durch physikalische Dampfabscheidung gebildet wird.

2. Verfahren nach Anspruch 1, bei dem die Zwischenschicht durch Amorphisierung gebildet wird und die Amorphisierung durch eine mit niedriger Energie und schwacher Dosierung durchgeführte Implantation oder durch physikalische Behandlung ausgeführt wird.

3. Verfahren nach Anspruch 1 oder Anspruch 2, bei dem ferner die Schritte der bildenden ersten Schicht, der Zwischenschicht auf der ersten Schicht und der zweiten Schicht auf der Zwischenschicht wenigstens einmal wiederholt werden.

4. Verfahren nach einem der vorhergehenden Ansprüche, bei dem der Schritt der Bildung der ersten und der zweiten Schicht das Bilden der ersten und der zweiten Schicht mit einer Dicke von 100 bis 200 nm (1000 bis 2000 Å) und der Zwischenschicht mit einer Dicke von 5 bis 50 nm (50 bis 500 Å) umfaßt.

## Revendications

1. Procédé pour former un revêtement contenant de l'aluminium ou du polysilicium de taille de grain contrôlée sur un substrat qui comprend la formation sur le substrat par dépôt sous vapeur chimique (CVD) d'une première couche d'aluminium ou de polysilicium, la formation d'une couche intermédiaire fine, différente en structure de grain de celle de la première couche, sur la première couche, et la formation par dépôt sous vapeur chimique sur la couche intermédiaire d'une seconde couche du même matériau que la première couche, **caractérisé en ce que** la couche intermédiaire est formée en rendant amorphe la surface de la première couche ou en déposant le même matériau qui forme la première couche par un dépôt sous vapeur physique ou un dépôt assisté par plasma.

2. Procédé selon la revendication 1, dans lequel la couche intermédiaire est formée par une opération de transformation amorphe et en ce que cette opération est réalisée par traitement physique ou par implant à dose modérée à faible énergie.

3. Procédé selon la revendication 1 ou 2, comprenant en outre la répétition des étapes de former ladite première couche, ladite couche intermédiaire sur ladite première couche et ladite seconde couche sur ladite couche intermédiaire au moins une fois.

4. Procédé selon l'une quelconque des revendications précédentes, dans lequel ladite étape de formation desdites première et seconde couches comprend la formation desdites première et seconde couches à une épaisseur de 100 à 200 nm (1000 à 2000 Å), et ladite couche intermédiaire à une épaisseur de 5 à 50 nm (50 à 500 Å).
